Europäisches Patentamt

European Patent Office

Office européen des brevets

(19)

(11) Numéro de publication : **0 372 643 B1**

(12) **FASCICULE DE BREVET EUROPEEN**

(45) Date de publication du fascicule du brevet :
**19.04.95 Bulletin 95/16**

(51) Int. Cl.⁶ : **H03F 3/193**

(21) Numéro de dépôt : **89203063.6**

(22) Date de dépôt : **04.12.89**

(54) **Dispositif semiconducteur intégré comprenant un étage amplificateur de puissance en hyperfréquences.**

(30) Priorité : **09.12.88 FR 8816231**

(43) Date de publication de la demande :
**13.06.90 Bulletin 90/24**

(45) Mention de la délivrance du brevet :
**19.04.95 Bulletin 95/16**

(84) Etats contractants désignés :
**DE FR GB IT**

(56) Documents cités :
**EP-A- 0 150 140**
**FR-A- 2 605 817**
**US-A- 4 658 220**
**CONFERENCE PROCEEDINGS OF THE 16TH EUROPEAN MICROWAVE CONFERENCE, Dublin, 8-12 septembre 1986, pages 631-635; V. PAUKER et al.: "Normally-off mesfet analoque circuits"**
**COMSAT TECHNICAL REVIEW, vol. 17, no. 1, 1987, pages 1-22; GUPTA et al: "Design and modeling of a GaAs monolithic 2- to 6-GHz feedback amplifier"**

(73) Titulaire : **LABORATOIRES D'ELECTRONIQUE PHILIPS**
**3, Avenue Descartes**
**F-94450 Limeil-Brévannes (FR)**
(84) **FR**
Titulaire : **Philips Electronics N.V.**
**Groenewoudseweg 1**
**NL-5621 BA Eindhoven (NL)**
(84) **DE GB IT**

(72) Inventeur : **Gamand, Patrice**
**Société Civile S.P.I.D.**
**209 rue de l'Université**
**F-75007 Paris (FR)**

(74) Mandataire : **Landousy, Christian et al**
**Société Civile S.P.I.D.**
**156, Boulevard Haussmann**
**F-75008 Paris (FR)**

EP 0 372 643 B1

## Description

L'invention concerne un dispositif semiconducteur intégré comprenant un étage amplificateur de puissance en hyperfréquences, à transistor à effet de champ, cet étage ayant un développement de grille de largeur W.

Un étage amplificateur est connu de la publication intitulée : "GaAs IC Direct coupled amplifiers" par D.HORNEBUCKLE dans "1980 IEEE/MTT Symposium Dig. p.387-389". Ce document décrit un étage amplificateur formé de trois transistors, l'entrée hyperfréquences étant appliquée sur la grille du premier transistor monté en inverseur dont le drain est couplé directement à la grille d'un second transistor. Le drain de ce second transistor est porté directement à une tension d'alimentation continue $V_{DD}$ et la source de ce second transistor est portée à travers des diodes au drain d'un quatrième transistor dont la grille et la source court-circuitée sont portées à une tension d'alimentation continue négative. Ce même drain est relié à la grille d'un troisième transistor monté en inverseur. La sortie hyperfréquences se fait sur le drain de ce dernier transistor. Ce circuit présente l'inconvénient d'être instable à haute fréquence et de générer aussi des oscillations. Cela est dû au fait qu'il est constitué d'un transistor monté en drain commun suivi d'un transistor monté en source commune. Ce document enseigne aussi que le coefficient de réflexion à l'entrée du circuit chargé par 50 ohms est supérieur à 1. En effet une résistance négative apparaît à l'entrée de ce circuit, ce qui n'est pas souhaitable pour un amplificateur.

Fondamentalement, un étage amplificateur de puissance est aussi connu de la publication intitulée "GaAs FET principles and technology par James V. DILORENZO, p.230 à 347". Ce document décrit notamment un étage amplificateur de puissance constitué d'un transistor à effet de champ de type interdigité composé d'une pluralité de doigts de grille intercalés entre des doigts de drain et de source. L'augmentation de la puissance de sortie d'un tel composant est obtenue en augmentant le nombre de doigts de grille, de drain et de source. Par taille du transistor, il faut entendre la dimension de la largeur de grille qui est aussi proportionnelle au nombre des doigts de grille.

Un des buts de l'invention est de fournir un étage amplificateur de puissance en hyperfréquences dont la sortie est augmentée par rapport à un étage amplificateur de puissance selon l'art antérieur de même développement de grille, à fréquence de fonctionnement égale.

Un autre but de l'invention est de fournir un étage amplificateur de puissance travaillant à des fréquences plus élevées que les étages connus de l'état de la technique à même puissance de sortie puur un développement de grille total égal.

Les buts de l'invention sont atteints au moyen d'un circuit tel que défini dans le préambule et en outre caractérisé en ce que cet étage comprend deux transistors $T_1$, $T_2$ à effet de champ, respectivement de largeurs de grille $W_1$ et $W_2$ telles que la somme de ces largeurs de grille $W_1 + W_2$ égale le développement W, en ce que ces transistors $T_1$ et $T_2$ sont munis de premiers moyens de connexion qui consistent à relier directement des drains couplés des deux transistors, le signal de sortie hyperfréquences étant disponible sur ces drains communs, et de seconds moyens de connexion qui consistent à relier la source du premier transistor ($T_1$) à la grille de l'autre transistor ($T_2$) dit second transistor, le signal d'entrée hyperfréquences étant appliqué sur la grille du premier transistor ($T_1$), et en ce que cet étage comprend aussi des moyens de polarisation en continu, et des moyens pour assurer le retour du courant continu à la masse.

L'invention sera mieux comprise au moyen de la description suivante illustrée par les figures annexées dont :

- les figures 1a à 1d qui représentent le circuit selon l'invention dans quatre variantes de réalisation ;
- la figure 2 qui représente le coefficient $S_{11}$, du circuit selon l'invention en trait plein, et d'un transistor
- la figure 4 qui représente le courant drain drain-source en fonction de la tension drain-source des mêmes éléments ;
- la figure 5 qui représente le gain G en fonction de la fréquence F, des mêmes éléments ;
- la figure 6 qui représente un amplificateur à grand gain incluant un circuit selon la figure 1b ;
- la figure 7 qui représente la puissance de sortie en fonction de la puissance d'entrée du circuit de la figure 6.

## EXEMPLE I

Un des buts de l'invention est de fournir un étage amplificateur de puissance en hyperfréquences dont la sortie est augmentée par rapport à un étage amplificateur de puissance selon l'art antérieur de même développement de grille, à fréquence de fonctionnement égale.

Un autre but de l'invention est de fournir un étage amplificateur de puissance travaillant à des fréquences plus élevées que les étages connus de l'état de la technique à même puissance de sortie pour un développement de grille total égal.

Tel que représenté sur la figure 1a, le circuit selon l'invention comprend un premier transistor $T_1$ dont la grille G1 reçoit le signal d'entrée hyperfréquences. Ce circuit comprend aussi un second transistor $T_2$ dont le drain $D_2$ fournit le signal de sortie hyperfréquences.

Le transistor $T_1$ du circuit selon l'invention a une largeur de grille $W_1$ et le transistor $T_2$ une largeur de grille $W_2$. On comparera ci-après les performances du circuit selon l'invention avec les performances d'un étage amplificateur de puissance tel que décrit dans le document de l'état de la technique cité en second et dont la largeur de grille est $W = W_1 + W_2$.

Selon l'invention les drains $D_1$ du premier transistor $T_1$ et $D_2$ du second transistor $T_2$ sont reliés directement, ce qui constitue un moyen pour agir sur la puissance de sortie par unité de largeur de grille de l'étage formé par les deux transistors.

Le circuit selon l'invention présente en outre des moyens pour agir sur la valeur de la capacité d'entrée de l'étage de façon à diminuer cette capacité, ces moyens consistent à relier la source $S_1$ du premier transistor $T_1$ à la grille G2 du second transistor $T_2$.

Enfin le dispositif selon l'invention peut être inséré entre deux réseaux d'adaptation (non représentés), un réseau d'adaptation pour l'entrée et un réseau d'adaptation pour la sortie, de manière à former un circuit amplificateur conventionnel. Le circuit d'adaptation pour l'entrée sera muni de moyens pour polariser la grille du premier transistor et le circuit d'adaptation pour la sortie sera muni de moyens pour polariser simultanément les drains des deux transistors.

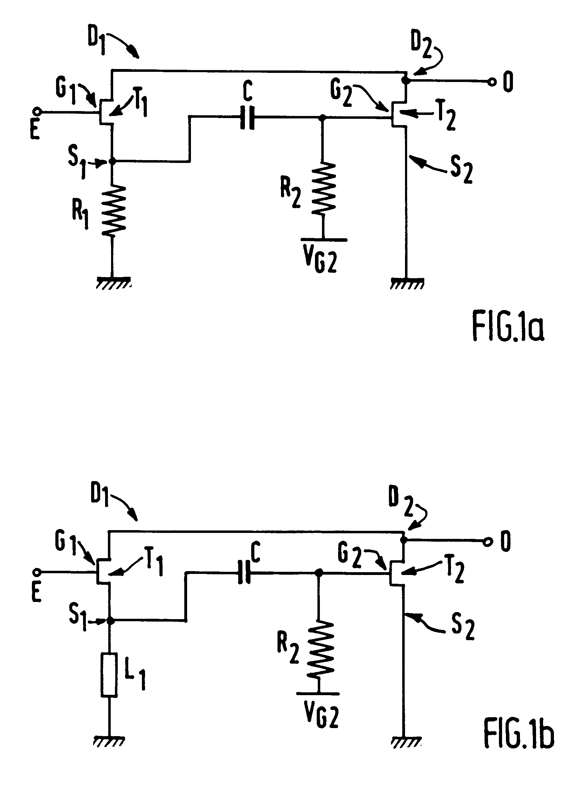

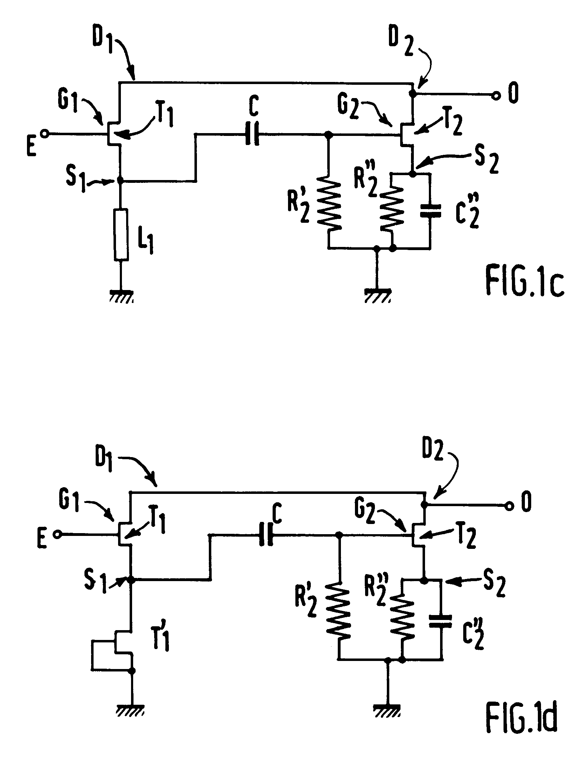

Des moyens sont en outre prévus pour assurer le retour du courant continu à la masse. A cet effet, la source $S_1$ du premier transistor peut être connectée à la masse à travers une résistance $R_1$ comme montré sur la figure 1a, ou bien à travers une ligne hyperfréquences $L_1$ comme montré sur la figure 1b, ou encore par un transistor $T'_1$ monté en résistance comme montré sur la figure 1d.

Pour obtenir ce dernier montage (figure 1d), la grille et la source court-circuitées du transistor $T'_1$ sont portées à la masse, et son drain est relié à la source du premier transistor $T_1$.

Dans le montage représenté sur la figure 1b, la ligne hyperfréquences $L_1$ pourra présenter favorablement une valeur égale au quart de la longueur d'onde de la fréquence du signal d'entrée.

Le circuit selon l'invention comprend aussi des moyens de polarisation qui, tels que représentés sur les figures 1a et 1b, consistent en une résistance $R_2$ disposée entre l'électrode de grille du second transistor $T_2$ et une tension d'alimentation continue $V_{G2}$. Dans ce cas la source $S_2$ du second transistor $T_2$ est connectée directement à la masse.

Dans une variante de l'invention, représentée sur les figures 1c et 1d, les moyens de polarisation comprennent une résistance $R'_2$ disposée entre la grille $G_2$ du second transistor et la masse, et une résistance $R''_2$ montée en parallèleavec une capacité de découplage $C''_2$ disposée entre la source $S_2$ du second transistor et la masse. Dans cette variante, le transistor $T_2$ est dit auto-polarisé.

Enfin le découplage en continu peut être assuré en disposant une capacité C entre la source du premier transistor et la grille du second transistor.

Dans l'une ou l'autre des variantes de l'invention, la ligne de transmission $L_1$ peut être de type microruban ou coplanaire déposée sur un substrat semi-isolant par exemple le substrat recevant les transistors $T_1$ et $T_2$ ou sur un substrat en alumine ou sur un autre substrat.

Le circuit selon l'invention sera favorablement réalisé avec les éléments dont les valeurs sont rassemblées dans le tableau I.

De plus, de préférence le circuit selon l'invention sera réalisé sur un substrat en arséniure de gallium au moyen de transistors à effet de champ.

Le calcul de l'impédance d'entrée du circuit selon l'invention montre que la partie réelle de cette impédance est toujours supérieure à 0.

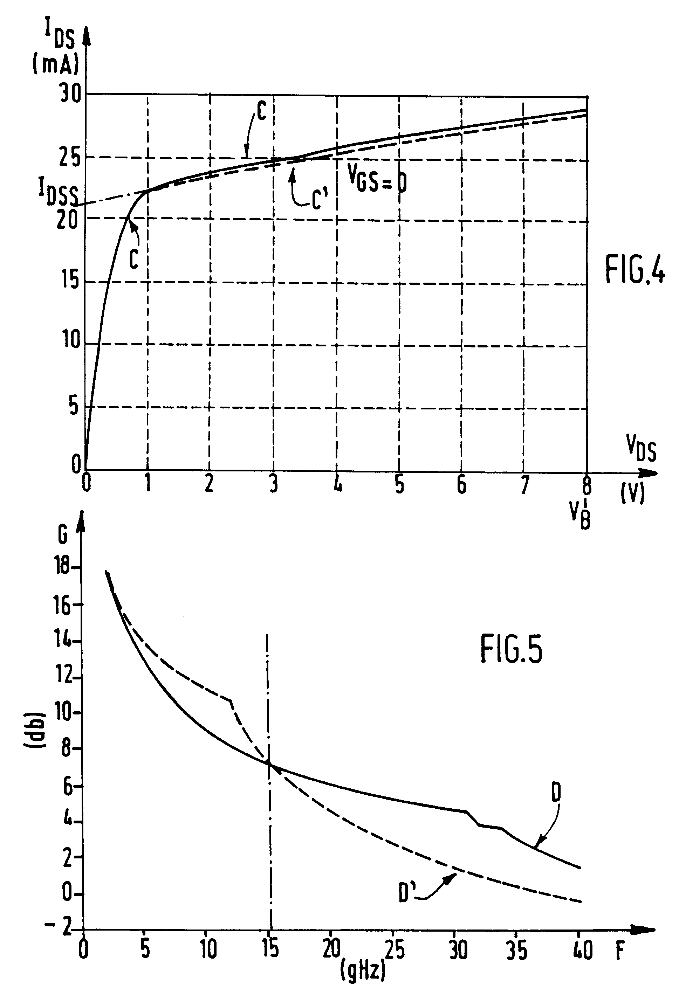

La figure 3 représente le module de cette impédance d'entrée $Z_E$ en fonction de la fréquence F en trait plein (courbe B) comparée au module de l'impédance d'entrée d'un circuit formé d'un seul transistor de puissance de même développement total de grille (courbe B').

La figure 3 montre qu'à développement de grille égal, l'impédance d'entrée du circuit selon l'invention est plus élevée que celle d'un seul transistor tel utilisé dans le second document cité.

Or il est connu que l'impédance d'entrée d'un transistor est inversement proportionnelle à sa largeur de grille. Il est d'autre part connu que si l'on veut augmenter la puissance de sortie de l'étage comportant ce transistor, il faut augmenter la largeur de grille de ce transistor. Donc, si l'on veut augmenter la puissance de sortie d'un étage selon l'état de la technique connu du second document cité, on diminue automatiquement son impédance d'entrée, ce qui est un grave inconvénient, car l'adaptation à l'entrée devient alors difficile.

Selon l'invention, on pourra augmenter la puissance de sortie de l'étage en augmentant la largeur de grille $(W_1, W_2)$ des deux transistors $T_1$, $T_2$, du fait que la diminution de l'impédance d'entrée qui en aurait résulté avec un dispositif connu est ici compensée.

D'autre part, il est également connu que l'augmentation de la largeur de grille d'un transistor entraîne l'augmentation de la capacité parasite à l'entrée. Selon l'invention cet inconvénient est évité. En effet, la capacité gênante au premier ordre est ici donnée par :

$$(C_1 + C_2)/2,$$

$C_1$ étant la capacité d'entrée du transistor $T_1$,

$C_2$ étant la capacité d'entrée du transistor $T_2$.

La capacité gênante est donc plus faible que celle du dispositif connu à développement de grille égal.

Selon l'invention on peut donc :

- soit augmenter la puissance de l'étage en augmentant la largeur des transistors et en évitant les inconvénients du circuit connu, à fréquence de coupure égale, la fréquence de coupure étant limitée par la capacité d'entrée ;
- soit augmenter la fréquence de coupure en conservant la même puissance de sortie.

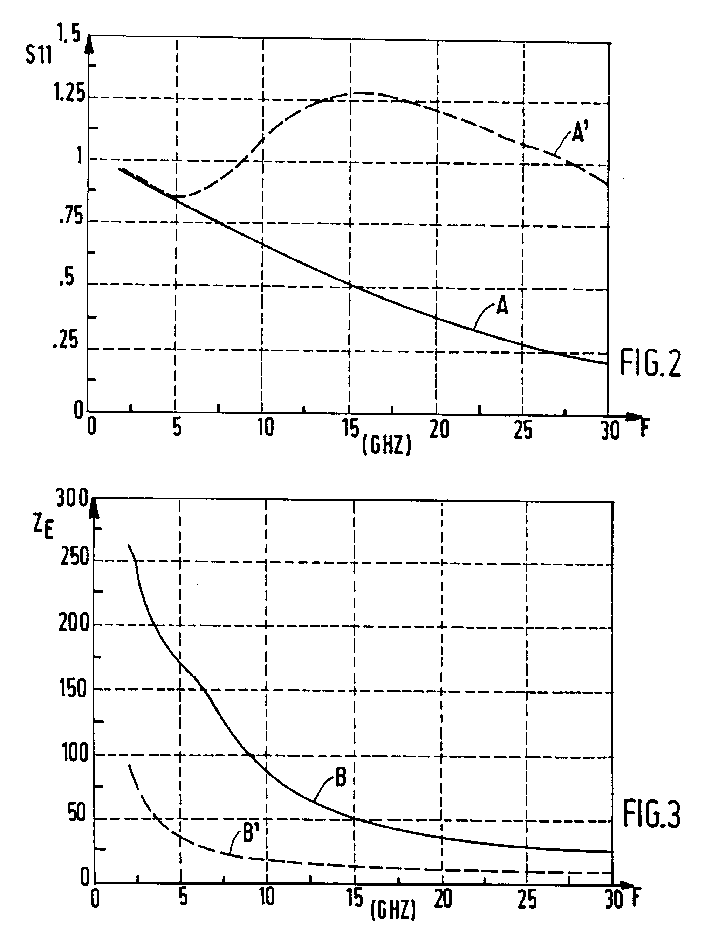

La figure 2 représente en trait plein le coefficient de réflexion $S_{11}$ à l'entrée du circuit (courbe A) et en trait discontinu le coefficient de réflexion d'un étage formé d'un seul transistor de même développement de grille (courbe A'). On constate que l'étage selon l'invention présente un coefficient de réflexion à l'entrée S11 toujours inférieur à 1, ce qui est plus favorable à la réalisation d'un amplificateur.

La figure 4 représente les caractéristiques du courant total de sortie $I_{DS}$ en fonction de la tension de sortie $V_{DS}$ dans le cas de l'étage selon l'art antérieur en trait discontinu (courbe C') et dans le cas du circuit selon l'invention (courbe C) en trait plein, pour une polarisation d'entrée grille-source $V_{GS} = 0$ volt.

La puissance maximale de sortie peut être calculée à partir de ces courbes et vaut pour le circuit selon l'invention :

$$P_{max} = 1/8.V_B \times I_{DSS}.$$

ou $V_B$ est la tension d'avalanche, et $I_{DSS}$ le courant drain-source à saturation.

Les puissances de sortie théoriques du circuit selon l'invention et du circuit selon l'art antérieur sont donc identiques. Mais l'impédance d'entrée étant plus forte dans le circuit selon l'invention, on peut donc atteindre cette puissance de sortie à une fréquence beaucoup plus élevée.

De plus, la polarisation de la grille du second transistor du circuit selon l'invention joue comme une commande de réglage et permet d'ajuster cette puissance de sortie.

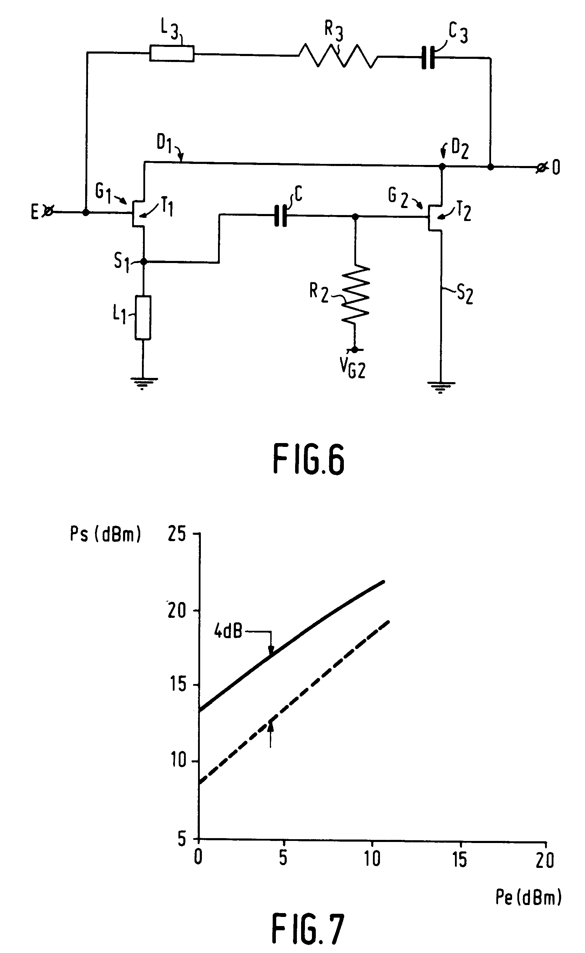

La figure 5 représente le gain maximal G en trait plein (courbe D) pour le circuit selon l'invention et en trait discontinu (courbe D') pour l'étage à un transistor selon l'art antérieur en fonction de la fréquence F. Ces courbes montrent que le gain est plus élevé d'environ 2dB pour le circuit selon l'invention et ceci sur une très large bande de fréquence.

A largeur égale de développement total de grille de transistor, l'amplificateur selon le montage de l'exemple I, a donc toujours un gain très supérieur à celui d'un montage utilisant un seul transistor.

Le circuit selon l'invention montre donc les avantages suivants :

- il est plus stable ;
- il montre une impédance d'entrée plus forte ;
- il présente un gain plus élevé en haute fréquence ;
- le gain peut être contrôlé par le choix de la polarisation de grille du second transistor ;
- une forte puissance de sortie donnée peut être atteinte à une fréquence beaucoup plus élevée ;
- les tailles des transistors peuvent être choisies pour privilégier l'un des points cités ci-dessus.

| TABLEAU I | | |
|---|---|---|
| Transistors | Résistances | Capacités |
| $\ell_1 = 0,5\ \mu m$<br>$T_1\ \{$<br>$W_1 = 100\ \mu m$ | $R_1 = 1\ k\Omega$<br><br>$R_2 = 1\ k\Omega$ | $C = 5\ pF$<br>$C''_2 = 5\ pF$ |
| $\ell_2 = 0,5\ \mu m$<br>$T_2\ \{$<br>$W_2 = 100\ \mu m$ | $R'_2 = 1\ k\Omega$<br><br>$R''_2 = 10\ à\ 30\ \Omega$ | |

Dans ce tableau $\ell_1$ et $\ell_2$ sont les longueurs de grille des transistors $T_1$ et $T_2$ respectivement, et $W_1$ et $W_2$ leur largeur de grille.

Exemple II

Dans ce second exemple, on décrit un amplificateur, qui à partir d'un amplificateur selon l'exemple I, permet d'obtenir un gain encore supérieur, et une parfaite stabilité.

Tel que représenté sur la figure 6, le circuit amplificateur à grand gain est constitué du circuit de la figure 1b doté en outre d'une contre-réaction disposée entre sa sortie 0 ou drain du transistor $T_2$, et son entrée E ou grille du transistor $T_1$. L'amplificateur grand gain pourrait aussi être une variante des circuits des figures 1a, 1c ou 1d.

Quelle que soit la bande de fréquence utilisée, le circuit selon la figure 6 est stable, lorsque la contre-réaction est négative, par exemple formée d'une self-inductance $L_3$ en série avec une résistance $R_3$ et une capacité $C_3$.

Dans cet exemple, les éléments peuvent avoir les valeurs indiquées dans le tableau I, pour ceux qui sont communs avec l'une des figures 1 à l'exception de la taille des transistors, et les valeurs indiquées dans le tableau II pour ceux qui forment la contre-réaction.

| TABLEAU II |
|---|
| $R_3 \simeq 125$ $\Omega$ |
| $L_3 \simeq 3$ x $2615$ µm |
| $C_3 \simeq 7$ pF |
| $T_1$ { $\quad \ell_1 = 0,5$ µm $\quad W_1 = 500$ µm |
| $T_2$ { $\quad \ell_2 = 0,5$ µm $\quad W_2 = 500$ µm |

Dans l'exemple réalisé au moyen des éléments du tableau II, la self-inductance est une ligne hyperfréquences.

La figure 7 montre la puissance de sortie $P_S$ en dBm en fonction de la puissance d'entrée $P_e$ en dBm du circuit de la figure 6. La puissance de sortie dans la gamme 0 à 10 dBm du signal d'entrée est de l'ordre de 4 dB supérieure par rapport à celle d'un circuit à un seul transistor de même dimension. Le gain en puissance est donc double, dans cette gamme de signal d'entrée, de ce que l'on obtient au moyen des circuits des figures 1, et la stabilité est encore améliorée.

On utilisera de préférence le circuit de l'exemple I pour des amplificateurs dits de puissance, et le circuit de l'exemple II pour réaliser des amplificateurs dits à grand gain.

On peut par ailleurs, au moyen du circuit décrit dans l'exemple II, réaliser un oscillateur en choisissant les éléments de la boucle de contre-réaction pour former une contre-réaction positive. Une telle variante étant, avec les éléments déjà décrits pour réaliser l'exemple 1, à la portée de tout homme du métier, n'est pas décrite plus avant.

## Revendications

1. Dispositif semiconducteur intégré comprenant un étage amplificateur de puissance en hyperfréquences, à transistor à effet de champ, cet étage ayant un développement de grille de largeur W, caractérisé en ce que cet étage comprend deux transistors $T_1$, $T_2$ à effet de champ, respectivement de largeurs de grille $W_1$ et $W_2$ telles que la somme de ces largeurs de grille $W_1 + W_2$ égale le développement W, en ce que ces transistors $T_1$ et $T_2$ sont munis de premiers moyens de connexion qui consistent à relier directement des drains couplés des deux transistors, le signal de sortie hyperfréquences étant disponible sur ces drains communs, et de seconds moyens de connexion qui consistent à relier la source du premier transistor ($T_1$) à la grille de l'autre transistor ($T_2$) dit second transistor, le signal d'entrée hyperfréquences étant appliqué sur la grille du premier transistor ($T_1$), et en ce que cet étage comprend aussi des moyens de polarisation en continu, et des moyens pour assurer le retour du courant continu à la masse.

2. Dispositif selon la revendication 1, caractérisé en ce que les moyens pour assurer le retour du courant continu à la masse comprennent une ligne hyperfréquences disposée entre la source dudit premier transistor et la masse.

3. Dispositif selon la revendication 2, caractérisé en ce que la ligne hyperfréquences a une valeur égale au quart de la longueur d'onde de la fréquence du signal d'entrée.

4.  Dispositif selon la revendication 1, caractérisé en ce que les moyens pour assurer le retour du courant continu à la masse comprennent une résistance de forte valeur disposée entre la source dudit premier transistor et la masse.

5.  Dispositif selon la revendication 4, caractérisé en ce que la résistance est constituée par un transistor dont la grille et la source court-circuitées sont portées à la masse, le drain étant relié à la source dudit premier transistor.

6.  Dispositif selon l'une des revendications 2 à 5, caractérisé en ce que les moyens de polarisation comprennent une forte résistance disposée entre l'électrode de grille dudit second transistor et une borne d'alimentation continue, et la connexion directe de la source du second transistor à la masse.

7.  Dispositif selon l'une des revendications 2 à 5, caractérisé en ce que les moyens de polarisation comprennent d'une part une résistance disposée entre l'électrode de grille dudit second transistor et la masse, et d'autre part une résistance et une capacité de découplage montées en parallèle entre la source dudit second transistor et la masse.

8.  Dispositif selon l'une des revendications 4 à 7, caractérisé en ce qu'une capacité de découplage en continu est disposée entre la source dudit premier transistor et la grille dudit second transistor.

9.  Dispositif selon l'une des revendications précédentes, caractérisé en ce que les moyens de polarisation en continu comprennent la connexion de l'entrée de l'étage amplificateur à undit premier circuit d'adaptation, muni de moyens pour polariser la grille du premier transistor ($T_1$), et la connexion de la sortie de l'étage amplificateur à undit second circuit d'adaptation muni de moyens pour polariser simultanément les drains des deux transistors ($T_1,T_2$).

10. Dispositif selon l'une des revendications précédentes, caractérisé en ce qu'il comprend en outre une boucle de contre-réaction positive.

11. Dispositif selon la revendication 10, caractérisé en ce que la boucle de contre-réaction positive comprend, disposées en série, une self-inductance, une résistance et une capacité.

12. Dispositif selon la revendication 11, caractérisé en ce que la self inductance est une ligne hyperfréquences.

13. Dispositif selon l'une des revendications 1 à 10, caractérisé en ce qu'il comprend en outre une boucle de contre-réaction négative.


## Patentansprüche

1.  Integrierte Halbleiteranordnung, die eine Ultrahochfrequenz-Leistungsverstärkerstufe mit Feldeffekttransistor umfaßt, wobei diese Stufe eine Gate-Erweiterung mit der Breite W hat, dadurch gekennzeichnet, daß diese Stufe zwei Feldeffekttransistoren $T_1$ und $T_2$ mit einer Gate-Breite von $W_1$ beziehungsweise $W_2$ umfaßt, so daß die Summe dieser Gate-Breiten $W_1+W_2$ gleich der Erweiterung W ist, daß die Transistoren $T_1$ und $T_2$ mit ersten Verbindungsmitteln zur direkten Verbindung der gekoppelten Drains beider Transistoren versehen sind, wobei das Ultrahochfrequenz-Ausgangssignal an diesen gemeinsamen Drains verfügbar ist, und mit zweiten Verbindungsmitteln zur Verbindung der Source des ersten Transistors ($T_1$) mit dem Gate des anderen mit zweitem Transistor bezeichneten Transistors ($T_2$) versehen ist, wobei das Ultrahochfrequenz-Eingangssignal dem Gate des ersten Transistors zugeführt wird, und daß diese Stufe außerdem Mittel zur Gleichspannungs-Vorspannung sowie Mittel umfaßt, die für den Rückfluß des Gleichstroms zur Masse sorgen.

2.  Anordnung nach Anspruch 1, dadurch gekennzeichnet, daß die Mittel, die für den Rückfluß des Gleichstroms zur Masse sorgen, eine zwischen der Source des genannten ersten Transistors und Masse angeordnete Ultrahochfrequenz-Leitung umfassen.

3.  Anordnung nach Anspruch 2, dadurch gekennzeichnet, daß die Ultrahochfrequenz-Leitung einen Wert hat, der gleich dem Viertel der Wellenlänge der Frequenz des Eingangssignals ist.

**4.** Anordnung nach Anspruch 1, <u>dadurch gekennzeichnet</u>, daß die Mittel, die für den Rückfluß des Gleichstroms zur Masse sorgen, einen Widerstand mit hohem Wert umfassen, der zwischen der Source des genannten ersten Transistors und Masse angeordnet ist.

**5.** Anordnung nach Anspruch 4, <u>dadurch gekennzeichnet</u>, daß der Widerstand von einem Transistor gebildet wird, dessen Gate und kurzgeschlossene Source an Masse gelegt sind, wobei der Drain mit der Source des genannten ersten Transistors verbunden ist.

**6.** Anordnung nach einem der Ansprüche 2 bis 5, <u>dadurch gekennzeichnet</u>, daß die Vorspannungsmittel einen hohen Widerstand umfassen, der zwischen dem Gate-Anschluß des genannten zweiten Transistors und einer Gleichstromversorgungsklemme angeordnet ist, sowie die direkte Verbindung der Source des zweiten Transistors mit Masse umfassen.

**7.** Anordnung nach einem der Ansprüche 2 bis 5, <u>dadurch gekennzeichnet</u>, daß die Vorspannungsmittel erstens einen Widerstand umfassen, der zwischen dem Gate-Anschluß des genannten zweiten Transistors und Masse angeordnet ist, und zweitens einen Widerstand und eine Entkopplungskapazität umfassen, die parallel zwischen der Source des genannten zweiten Transistors und Masse angeordnet sind.

**8.** Anordnung nach einem der Ansprüche 4 bis 7, <u>dadurch gekennzeichnet</u>, daß eine Gleichspannungsentkopplungs-Kapazität zwischen der Source des genannten ersten Transistors und dem Gate des genannten zweiten Transistors angeordnet ist.

**9.** Anordnung nach einem der vorstehenden Ansprüche, <u>dadurch gekennzeichnet</u>, daß die Gleichspannungs-Vorspannungsmittel die Verbindung des Eingangs der Verstärkerstufe mit einer genannten ersten Anpassungsschaltung umfassen, die mit Mitteln zur Vorspannung des Gate des ersten Transistors ($T_1$) versehen ist, sowie die Verbindung des Ausgangs der Verstärkerstufe mit einer genannten zweiten Anpassungsschaltung umfassen, die mit Mitteln zur gleichzeitigen Vorspannung der Drains der beiden Transistoren ($T_1$, $T_2$) versehen ist.

**10.** Anordnung nach einem der vorstehenden Ansprüche, <u>dadurch gekennzeichnet</u>, daß sie außerdem eine positive Rückkopplungsschleife umfaßt.

**11.** Anordnung nach Anspruch 10, <u>dadurch gekennzeichnet</u>, daß die positive Rückkopplungsschleife in Reihe eine Drossel, einen Widerstand und eine Kapazität umfaßt.

**12.** Anordnung nach Anspruch 11, <u>dadurch gekennzeichnet</u>, daß die Drossel eine Ultrahochfrequenz-Leitung ist.

**13.** Anordnung nach einem der Ansprüche 1 bis 10, <u>dadurch gekennzeichnet</u>, daß sie außerdem eine negative Rückkopplungsschleife umfaßt.

## Claims

**1.** An integrated semiconductor device, comprising an ultra-high frequency power amplifier stage of the field-effect transistor type, said stage having an extended gate of width W, characterized in that said stage comprises two field-effect transistors $T_1$, $T_2$, having a gate width $W_1$ + $W_2$, is equal to the extension W, in that the transistors $T_1$ and $T_2$ are provided with first connection means directly interconnecting the coupled drains of the two transistors, the ultra-high frequency output signal being available at these common drains, and second connection means connecting the source of the first transistor ($T_1$) to the gate of the other transistor ($T_2$), referred to as the second transistor, the ultra-high frequency input signal being applied to the gate of the first transistor ($T_1$), and in that said stage also comprises D.C. biasing means and means to ensure the feedback of the D.C. current to ground.

**2.** A device claimed in Claim 1, characterized in that the means to ensure the feedback of the D.C. current to ground comprise an ultra-high frequency line arranged between the source of said first transistor and ground.

**3.** A device as claimed in Claim 2, characterized in that the ultra-high frequency line has a value equal to one quarter of the wavelength of the frequency of the input signal.

4. A device as claimed in Claim 1, characterized in that the means to ensure the feedback of the D.C. current to ground comprise a resistor of high value which is inserted between the source of said first transistor and ground.

5. A device as claimed in Claim 4, characterized in that the resistor is constituted by a transistor whose short-circuited gate and source are connected to ground, the drain being connected to the source of said first transistor.

6. A device as claimed in one of the Claims 2 to 5, characterized in that the biasing means comprise a resistor of high value which is arranged between the gate electrode of said second transistor and a D.C. supply terminal, and the direct connection of the source of the second transistor to ground.

7. A device as claimed in one of the Claims 2 to 5, characterized in that the biasing means comprise on the one hand a resistor inserted between the gate electrode of said second transistor and ground, and on the other hand a resistor and a decoupling capacitor connected in parallel between the source of said second transistor and ground.

8. A device as claimed in one of the Claims 4 to 7, characterized in that a D.C. uncoupling capacitor is inserted between the source of said first transistor and the gate of said second transistor.

9. A device as claimed in one of the preceding Claims, characterized in that the D.C. biasing means comprise the connection of the input of the amplifier stage to a so-called first matching circuit, provided with means for biasing the gate of the first transistor ($T_1$), and the connection of the output of the amplifier stage to a so-called second matching circuit, provided with means for simultaneously biasing the drains of the two transistors ($T_1$, $T_2$).

10. A device as claimed in one of the preceding Claims, characterized in that it also comprises a positive feedback loop.

11. A device as claimed in Claim 10, characterized in that the positive feedback loop comprises a series connection of a self-inductance, a resistor and a capacitor.

12. A device as claimed in Claim 11, characterized in that the self-inductance is an ultra-high frequency line.

13. A device as claimed in one of the Claims 1 to 10, characterized in that it also comprises a negative feedback loop.

FIG.1a

FIG.1b

FIG.1c

FIG.1d

FIG.2

FIG.3

FIG.4

FIG.5

FIG.6

FIG.7